Europäisches Patentamt

European Patent Office

Office européen des brevets

(19)

(11) Numéro de publication : **0 116 509**
**B1**

(12)

# FASCICULE DE BREVET EUROPÉEN

(45) Date de publication du fascicule du brevet :
**11.11.87**

(21) Numéro de dépôt : **84420020.4**

(22) Date de dépôt : **03.02.84**

(51) Int. Cl.⁴ : **G 01 R 15/02**

(54) **Capteur dynamique de courant.**

(30) Priorité : **08.02.83 CA 421127**

(43) Date de publication de la demande :
**22.08.84 Bulletin 84/34**

(45) Mention de la délivrance du brevet :
**11.11.87 Bulletin 87/46**

(84) Etats contractants désignés :
**AT BE CH DE FR GB IT LI LU NL SE**

(56) Documents cités :
**CA-A- 1 151 242**
**FR-A- 2 384 265**
**GB-A-  229 881**
**US-A- 4 070 572**
**MESURES, REGULATION, AUTOMATISME, vol. 40,
no. 9, septembre 1975, pages 56-60, Paris, FR F.
RIOUX-DAMIDAU: "Mesure des courants intenses
par sondes à débit interne"**
**IEEE TRANS. POWER APPAR. & SYSTEMS, vol. PAS-
97, no. 3, mai/juin 1978, pages 893-901, IEEE, New
York, US R. MALEWSKI et al.: "Transient measurements techniques in EHV systems"**

(73) Titulaire : **HYDRO-QUEBEC**
**75, Boulevard Dorchester Ouest**
**Montréal Québec H2Z 1A4 (CA)**

(72) Inventeur : **Mercure, Hubert P.**
**271 Demers**
**Beloeil (Québec) (CA)**
Inventeur : **Drouet, Michel G.**
**1825 Du Bocage**
**Saint Bruno (Québec) (CA)**

(74) Mandataire : **Maureau, Bernard**
**Cabinet GERMAIN & MAUREAU Le Britannia - Tour C**
**20, Boulevard Eugène Déruelle**
**F-69003 Lyon (FR)**

## 0 116 509

### Description

La présente invention a pour objet un capteur dynamique de courant de type perfectionné, destiné à équiper une ligne d'alimentation électrique à très fort courant et à haute ou très haute tension utilisable notamment dans tout circuit où les variations de courant dans le temps sont importantes et où une analyse des fluctuations rapides de ce courant est requise, ainsi que dans tout circuit d'appareillage ou de composantes électriques où de très forts courants alternatifs doivent être mesurés sur de longues périodes ou encore de façon permanente.

L'invention a donc pour objet un capteur dynamique de courant de type perfectionné qui peut être utilisé, par exemple, comme moniteur de courant non saturable et à échauffement minime pour le développement d'appareillages électriques de puissance tels que des disjoncteurs, commutateurs ou parafoudres, qui sont sujets à des courants post-arcs ou bien à des courants élevés et à front raide tel que par exemple un choc de la foudre, sous haute ou basse tension. De même, le capteur dynamique de courant de type perfectionné selon l'invention peut être utilisé en remplacement d'un transformateur de courant utilisé conventionnellement dans un réseau électrique à haute tension.

Il est connu que l'enregistrement de courant post-arc d'un disjoncteur est essentiel à la compréhension des phénomènes qui entourent le fonctionnement de celui-ci. On sait en effet que la qualité d'un disjoncteur dépend de l'intensité ainsi que de l'évolution temporelle de ce courant post-arc, qui est habituellement faible (inférieur à 10 ampères) et à front très raide (de l'ordre de quelques microsecondes tout au plus). On sait d'autre part que le développement de disjoncteurs plus rapides opérant à plus haute tension et pouvant couper des courants de plus en plus élevés est axé sur le contrôle des caractéristiques de l'arc dans le disjoncteur.

L'évolution dynamique du faible courant qui suit l'amorce de coupure du fort courant lorsque l'on actionne un disjoncteur, contient une information substantielle quant aux probabilités de succès et donc à la qualité du disjoncteur en question.

Or, on sait également que la mesure de ce faible courant s'avère en pratique difficile et nécessite jusqu'à présent l'utilisation de techniques de plus en plus élaborées (voir, à titre d'exemple, l'article de M. Murano et al., IEEE, P.E.S. Winter Meeting, paper No. T-75-70-8, 1975).

Une des techniques utilisées actuellement pour la mesure du faible courant qui suit l'amorce de coupure du fort courant dans un disjoncteur fait appel à l'utilisation de shunts ayant des sensibilités grandissantes, qui sont enclenchées successivement lorsque le courant d'arc diminue vers le 0 du courant où doit se produire la coupure du disjoncteur (voir l'article de G. Hortopan et Coll., Revue Générale de l'Electricité, n° 5, pages 332 à 343, 1981). Une autre technique utilisée actuellement pour la mesure de ce faible courant fait appel à l'utilisation de transformateurs à noyaux saturables, tels que ceux fabriqués et distribués par la société Pearson Electronics Inc., ou encore à des noyaux à effet Hall.

Si ces techniques connues présentent chacune des avantages, elles ont également toutes des inconvénients.

Ainsi, par exemple, dans le cas de la première des techniques précédemment mentionnées, l'utilisation d'un certain nombre de shunts en parallèle requiert l'opération et la synchronisation d'éléments actifs de contrôle électromécanique ou à état solide, ou encore d'un ou de plusieurs disjoncteurs rapides supplémentaires, ces derniers éléments servant également à protéger les shunts dans la phase fort courant.

De même, la seconde technique précédemment mentionnée présente un inconvénient majeur dans la mesure où les transformateurs à noyaux saturables ont une réponse en fréquence très limitée (voir l'article intitulé « Transient response of current transformers », IEEE Power Engineering Society, Power System Relaying Commitee, 76-CH-1130-4 TWR, 1976). De façon similaire, l'utilisation de transformateurs à noyaux à effet Hall présente un inconvénient majeur dans la mesure où de tels transformateurs requièrent un système actif important de même qu'une source de courant également importante.

D'autres techniques connues, comme celle utilisant des diodes rapides montées en parallèle avec des shunts afin d'écrêter les signaux trop importants, sont de leur côté très peu flexibles et souvent imprécises.

La présente invention a pour objet un capteur dynamique de courant dont l'utilisation permet avantageusement de remédier aux inconvénients précédemment mentionnés, dans la mesure où ce capteur peut supporter sans protection le fort courant avant l'ouverture d'un disjoncteur, et ce sans se saturer, de sorte que la mesure du faible courant qui suit demeure non seulement possible mais aisée.

Plus précisément, l'invention a pour objet un capteur dynamique de courant se présentant sous la forme d'un transformateur à très faible inductance dont la construction utilise le conducteur même de courant comme primaire, et une bobine toroïdale à noyau d'air insérée dans une cavité pratiquée dans ledit capteur comme secondaire.

L'utilisation d'une bobine toroïdale placée dans un plan orthogonal autour d'un conducteur traversé par un courant pour agir vis-à-vis de ce dernier comme un secondaire et ainsi permettre la mesure dudit courant, est fort connue depuis de très nombreuses années. Ce genre de bobine toroïdale qui comprend un certain nombre de spires enroulés régulièrement ou non sur un noyau diélectrique ayant une section constante ou non sur toute sa longueur, est habituellement désigné sous le nom de « bobine de

**0 116 509**

Rogowski » et l'utilisation de cette bobine comme moniteur de courant a déjà fait l'objet de nombreuses études scientifiques ainsi que de nombreux développements (voir, par exemple, l'article de D.G. Pellinen et al., Rev. Sci. Instrum. Volume 51, No 11, pages 1535 à 1540, novembre 1980, ou encore l'article de S. Lebada et coll., Revue Brown Boveri, No 10/11, pages 12 à 14, 1981). Un capteur radioélectrique de ce type est par ailleurs décrit dans le brevet GB-A-229 881.

Dans une telle bobine de Rogowski, la force contre-électromotrice ou tension $\varepsilon$ générée aux bornes de la bobine par un courant I circulant dans le conducteur entouré par ladite bobine est égale à :

$$\varepsilon = Ri \tag{I}$$

dans laquelle R est une résistance de lecture montée entre les bornes de la bobine, et i est l'intensité du courant circulant dans ladite résistance de lecture.

Or, on sait que, pour une telle bobine, en négligeant la capacité intrinsèque de celle-ci, l'intensité i est liée à la variation du flux à l'intérieur de ladite bobine par l'équation suivante :

$$\frac{1}{Z}\frac{d\Phi}{dt} = \frac{L}{Z}\frac{di}{dt} + i \tag{II}$$

dans laquelle Z représente l'impédance totale vue par le courant i (c'est-à-dire la somme de la résistance de lecture R, de la résistance du fil conducteur de la bobine et de la résistance pelliculaire qui dépend de la fréquence), et L représente l'inductance totale de ladite bobine.

Or, on sait également que, dans le cas simplifié d'une bobine de Rogowski dont l'axe central est aligné sur le conducteur, le flux induit dans ladite bobine est lié à l'intensité I passant dans le conducteur par l'équation :

$$\Phi(t) = \frac{N \cdot A \cdot \mu_0}{2\,\pi r} I(t) \tag{III}$$

dans laquelle :
N est le nombre de spires de la bobine ;
A est la section constante de chaque spire sur toute la longueur de la bobine ;
$\mu_0$ est la susceptibilité magnétique du vide ou la constante de champ magnétique ; et
r est le rayon moyen des spires.
Si par un choix approprié des caractéristiques de la bobine, on s'assure que :

$$\frac{L}{Z}\frac{di}{dt} \ll i \tag{IV}$$

ceci, dans le cas simple d'un courant alternatif de fréquence $\omega$, impliquant que le rapport de l'inductance de la bobine sur l'impédance totale vue par cette même bobine est très inférieur à la période du courant à capter, c'est-à-dire que :

$$\frac{L\omega}{Z} \ll 1 \quad \text{ou} \quad \frac{L}{Z} \ll \frac{T}{2\,\pi} \tag{V}$$

l'équation II se lit comme suit :

$$i = \frac{1}{Z}\frac{d\Phi}{dt} \tag{VI}$$

En combinaison cette équation VI avec les équations I et III précédemment mentionnées, on obtient alors :

$$\varepsilon = \frac{R}{Z} \cdot \frac{N \cdot A \cdot \mu_0}{2\,\pi r}\frac{dI}{dt} \tag{VII}$$

soit encore :

$$\varepsilon = k\frac{dI}{dt} \tag{VIII}$$

dans laquelle k est une constante de la bobine de Rogowski utilisée dans la plage délimitée pour le choix des paramètres de celle-ci.

Dans le cas particulier précédemment décrit, on constate donc que la bobine de Rogowski agit comme un « différenciateur », puisque la tension $\varepsilon$ à ses bornes est proportionnelle à la dérivée du

3

courant d'excitation.

Il est ici à noter que si les paramètres structurels de la bobine sont choisis de façon à ce que :

$$\frac{L}{Z}\frac{di}{dt} \gg i \qquad \text{(IX)}$$

l'intégration de l'équation II donne :

$$i = \Phi/L \qquad \text{(X)}$$

qui, reportée dans l'équation I donne :

$$\varepsilon = KI \qquad \text{(XI)}$$

dans laquelle K est une constante égale à R/N dans le cas simple d'un courant alternatif.

Dans ce cas particulier, la bobine agit alors comme un « intégrateur », comme c'est d'ailleurs le cas des transformateurs à noyau saturable utilisés couramment.

Le principal avantage d'utiliser une bobine de Rogowski dont la tension aux bornes est proportionnelle à la dérivée du courant d'excitation plutôt qu'au courant lui-même, c'est-à-dire d'utiliser une bobine de Rogowski du type différenciateur plutôt que d'utiliser une bobine de type intégrateur comme c'est le cas dans une foule de types de transformateurs de courant, est évident dans la mesure où une telle différenciation sert d'une part à éviter les phénomènes de saturation qui y sont rencontrés (la bobine n'ayant pas ici le noyau magnétisable nécessaire dans le cas où l'on exige un très grand rapport L/Z à faible fréquence) et, d'autre part, à éviter les courants trop élevés qui peuvent endommager la bobine puisque dans ce cas i = I/N.

Jusqu'à présent toutefois, l'utilisation de ce type de bobine de type différenciateur, a été systématiquement rejeté par de nombreux spécialistes dans le domaine des forts courants à cause de plusieurs inconvénients tels que ceux mentionnés à la page 436 de l'article précédemment mentionné de P.G. Pellinen et coll., Rev. Sci. Instrum., volume 51, n° 11, novembre 1980, et notamment à cause de l'inconvénient majeur constitué par le fait que la bobine peut générer de très hautes tensions lors de variations très rapides à fort courant, ce qui est dangereux pour l'opérateur et néfaste pour le système de mesure. De plus, lorsqu'il faut intégrer la tension de sortie de la bobine pour mesurer le courant circulant dans le conducteur, un faible niveau parasite comme un « offset » à basse fréquence en continu peut introduire une dérivée substantielle de l'intégrateur s'il ne peut être évité.

Selon l'invention, il a été découvert que cet inconvénient majeur qui, jusqu'à présent, a justifié dans la plupart des cas le rejet des bobines de Rogowski du type différenciateur, bien que ce type de bobine présente l'avantage d'éviter la saturation du noyau ou encore les dommages des courants trop élevés, peut être facilement contourné en choisissant judicieusement la construction de la bobine pour assurer un blindage adéquat et une isolation électrique suffisante de celle-ci et ainsi assurer une bonne sensibilité de mesure dans une plage prédéterminée, et ce tout en conservant au capteur des dimensions modestes et une construction simple.

Le document CA-A-1 151 242, publié le 2.8.83, concerne un capteur dynamique de courant destiné à équiper une ligne d'alimentation électrique à très fort courant et à haute ou très haute tension, du type comportant une bobine de Rogowski au centre de laquelle passe complètement une première pièce conductrice traversée par le courant à capter, la bobine étant choisie de façon que le rapport de sa self-inductance sur l'impédance totale vue de ladite bobine soit très inférieur à la période du courant à capter et une enceinte comportant une deuxième pièce conductrice entourant ladite bobine dans un but d'isolation de celle-ci, comportant un circuit de prétraitement de données alimenté par couplage capacitif. Ce type d'alimentation est très difficile à régulariser dans le cas de courants de très forte intensité. En outre, ce type de dispositif n'assure pas de parfaite protection des éléments du circuit de prétraitement qui se trouve sujet à un gradient de charge important.

Comme état de la technique est en outre cité le document US-A-4 070 572, qui décrit l'utilisation d'un circuit de prétraitement dont l'alimentation par courant de ligne est non intégrée. Ce type de dispositif est particulièrement gênant compte tenu des interférences qu'il crée par effet inductif ou offset.

L'invention se rapporte donc à un capteur dynamique de courant destiné à équiper une ligne d'alimentation électrique à très fort courant et à haute ou très haute tension, du type comportant une bobine de Rogowski au centre de laquelle passe complètement une première pièce conductrice traversée par le courant à capter, la bobine étant choisie de façon que le rapport de sa self-inductance sur l'impédance totale vue de ladite bobine soit très inférieur à la période du courant à capter et une enceinte comportant une deuxième pièce conductrice entourant ladite bobine dans un but d'isolation de celle-ci, caractérisé en ce que la première pièce conductrice comporte un corps cylindrique plein de diamètre inférieur au diamètre intérieur de la bobine, s'étendant perpendiculairement à une base de diamètre supérieur au diamètre extérieur de la bobine, en ce que la seconde pièce conductrice est montée sur la première et comporte un manchon épais entourant la première pièce conductrice et prenant contact sur la périphérie extérieure de la base tout autour de la bobine, le diamètre intérieur du manchon étant

4

0 116 509

légèrement supérieur au diamètre extérieur du corps cylindrique plein pour éviter tout contact avec ce dernier lorsque les pièces sont fixées, une première borne d'attache étant prévue à l'extrémité supérieure du corps cylindrique plein à l'opposé de ladite base et une deuxième borne d'attache étant prévue sur ledit manchon du même côté de la bobine que ladite première borne d'attache, ledit capteur comprenant en outre une troisième pièce en forme de boîtier fixé sous la base de la première pièce pour recevoir un circuit de prétraitement du courant capté par la bobine, ladite bobine étant reliée à l'intérieur dudit boîtier via une petite ouverture traversant ladite base ledit circuit de prétraitement étant alimenté par un transformateur d'alimentation intégré au capteur et constitué par une bobine toroïdale montée sur un noyau de ferrite, ledit transformateur étant lui-même alimenté par un élément de dérivation du courant intégré au capteur.

Le principal avantage du capteur dynamique de courant selon l'invention est, tel que précédemment indiqué, sa possibilité d'utilisation sans contrainte ni contrôle dans la phase fort courant du réseau tout autant que dans la phase transitoire rapide d'un faible courant post-arc, avec une sensibilité comparable dans les deux cas. Ainsi le capteur dynamique selon l'invention peut par exemple être utilisé pour la mesure des harmoniques supérieures à la fréquence nominale du réseau ou de toute perturbation du courant de ligne tel que les papillottements ou les courants d'orages magnétiques, ou encore des décharges partielles dans les conducteurs ou les appareillages sous-tension. Deux autres avantages du capteur dynamique de courant selon l'invention réside dans sa simplicité de construction et d'opération et dans ses dimensions modestes.

Grâce à sa structure, le capteur dynamique de courant selon l'invention est immunisé contre le bruit électromagnétique et le couplage inductif ou capacitif des circuits ou des équipements adjacents. Le capteur étant très faiblement inductif, ses contraintes d'isolation sont très peu sévères même pour des variations très rapides de courant.

Enfin, dans l'appareillage utilisant un tel capteur, la fidélité de l'enregistrement des signaux peut être assurée par un mode analogique de transmission par exemple par fibre optique, ce qui rend l'appareillage hautement performant.

Le capteur dynamique de courant selon l'invention est donc plus rapide, plus simple, mieux isolé et plus compact que les capteurs présentement utilisés comme moniteurs du courant post-arc d'un disjoncteur à l'essai ou en cours de développement. Comme le capteur selon l'invention est non saturable et à échauffement minime, il peut être utilisé dans tout circuit à courant alternatif élevé ainsi que dans toutes les situations de choc à courant élevé et front raide tel que par exemple les chocs générés par la foudre. Le capteur selon l'invention peut donc être également utilisé avantageusement pour remplacer les transformateurs de courant utilisés sur les réseaux électriques à haute ou très haute tension comme appareil de contrôle et de mesure.

L'invention ainsi que ses avantages seront mieux compris à la lecture de la description qui va suivre de plusieurs modes de réalisation préférés de celle-ci, avec référence aux dessins annexés dans lesquels :

la figure 1   est une vue schématique d'un appareil de mesure de courant incorporant un capteur dynamique de courant selon l'invention ;

la figure 2   est une vue en perspective ouverte du capteur dynamique de courant illustré de façon schématique sur la figure 1 ;

la figure 3   est une vue en coupe du capteur dynamique de courant illustré sur la figure 2 ;

la figure 4   est une vue en coupe d'un autre capteur dynamique de courant selon l'invention ;

la figure 5   est un schéma bloc du circuit optico-électronique utilisé dans l'appareil de mesure de courant illustré de façon schématique sur la figure 1 ;

la figure 6   est un schéma bloc du circuit d'alimentation par courant de ligne régularisé utilisé dans le capteur dynamique de courant illustré sur la figure 3 ;

la figure 7   est une vue schématique d'un pylône supportant une ligne de transport de courant et d'un autre type de capteur dynamique de courant de l'invention ; et

la figure 8   est une vue en perspective du capteur dynamique de courant illustré schématiquement sur la figure 7.

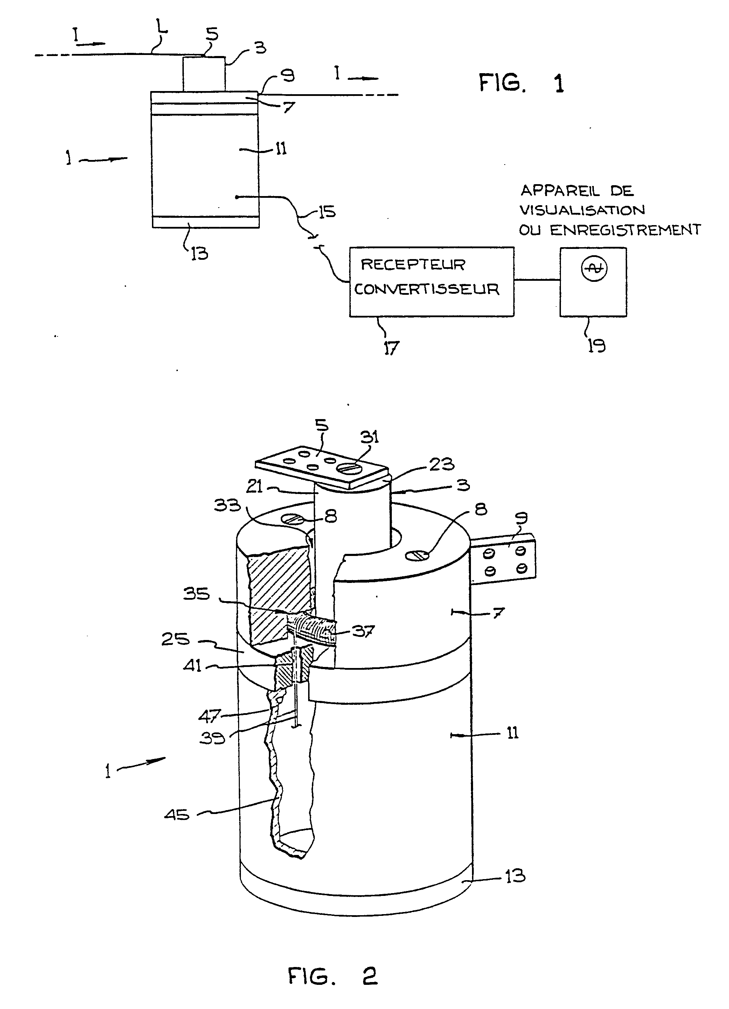

L'appareil de mesure de courant illustré de façon schématique sur la figure 1 comprend un capteur dynamique de courant 1 monté en série par deux bornes 5 et 9 sur une ligne L dans laquelle circule un courant I à mesurer. Tel qu'il sera décrit plus en détail ci-après, le capteur dynamique de courant 1 comprend une première pièce conductrice 3 à une des extrémités de laquelle se trouve la borne d'attache 5, une seconde pièce conductrice 7 sur laquelle est montée la borne d'attache 9, et une troisième pièce conductrice 11 en forme de boîtier, pourvue d'un fond 13.

Un circuit de prétraitement qui sera décrit dans les détails ci-après, est disposé à l'intérieur du boîtier 11 et est relié à un récepteur-convertisseur 17 par une fibre optique 15. La nécessité d'utiliser une telle transmission par fibre optique est due au problème d'isolation rencontrée dans le cas de ligne de transport de courant à très haute tension (735 kV par exemple). Le récepteur convertisseur 17 peut incorporer un appareil de visualisation ou d'enregistrement du signal capté et converti, ou être relié à un tel appareil de visualisation ou d'enregistrement indépendant 19.

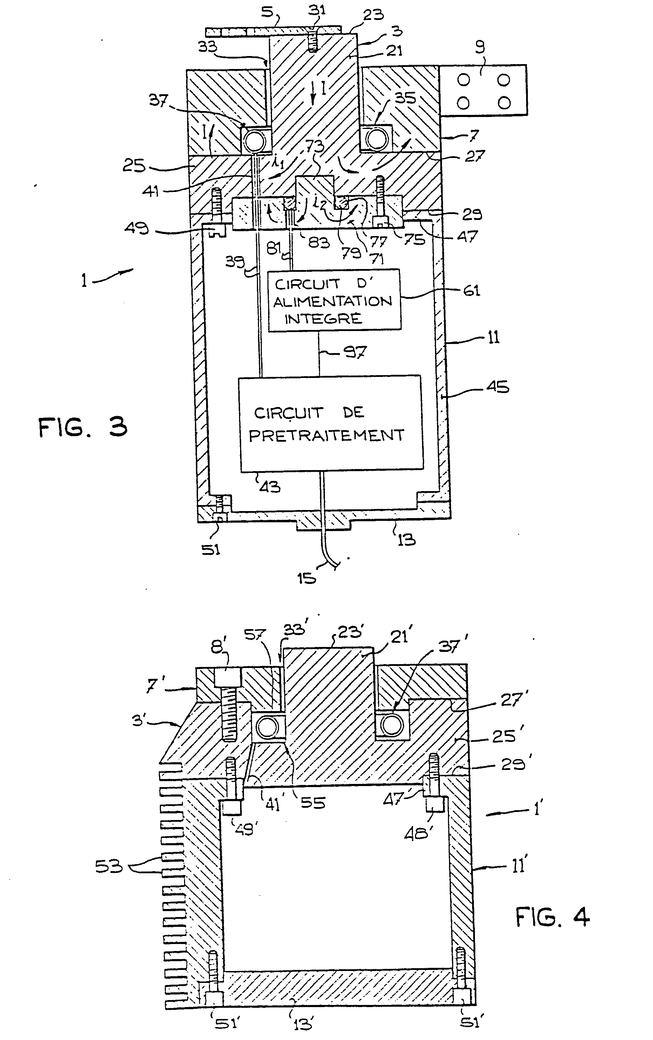

Tel qu'illustré sur les figures 2 et 3, le capteur dynamique de courant 1 comprend, comme principal élément, une bobine de Rogowski 37 montée entre les première et seconde pièces conductrices 3 et 7 de

5

façon à se comporter comme un transformateur de courant à très faible inductance aux bornes 39 duquel est générée une tension ε qui, selon le choix des paramètres géométriques et électriques de la bobine, peut être proportionnelle à la dérivée du courant I circulant dans la ligne L ou directement proportionnelle à ce courant I.

Pour les diverses raisons précédemment indiquées dans le préambule de la présente divulgation, ces paramètres sont de préférence choisis de façon à ce que la bobine agisse comme un différenciateur, et donc de façon à ce que la tension ε soit proportionnelle à la dérivée du courant I circulant dans la ligne L.

A ce sujet, il est à signaler que la forme de ce courant à mesurer n'a aucune importance et peut être aussi bien symétrique qu'asymétrique en amplitude et en fréquence, ou transitoire, la bobine fonctionnant avec une sensibilité appropriée et rigoureusement fixe dans tous les cas.

Selon le mode de réalisation illustré sur les figures 2 et 3, la première pièce conductrice 3 comprend un corps cylindrique plein 21 de diamètre inférieur au diamètre intérieur de la bobine. Cette pièce conductrice 21 s'étend perpendiculairement à une base 25 formant une partie intégrale de la pièce 3 et ayant un diamètre supérieur au diamètre extérieur de la bobine. L'extrémité supérieure 23 du corps cylindrique plein 21 à l'opposé de la base sert de point de fixation à la borne d'attache 5. Cette dernière qui peut être de n'importe quelle structure conventionnelle, peut être fixée à même l'extrémité 23 à l'aide d'une ou de plusieurs vis 31. L'utilisation d'un tel moyen de fixation amovible est avantageuse dans la mesure où il permet de retirer facilement la borne d'attache 5 pour procéder à l'assemblage des diverses pièces du capteur.

La seconde pièce conductrice 7 du capteur est façonnée et montée sur la première pièce de façon à recouvrir complètement la périphérie extérieure de la bobine tout en n'étant reliée électriquement qu'à l'extrémité de ladite première pièce conductrice à l'opposé de celle où se trouve la première borne d'attache 5.

Plus précisément, la seconde pièce conductrice 7 a la forme d'un manchon épais dont le diamètre extérieur est choisi de façon à être sensiblement identique au diamètre extérieur de la base 25 de la première pièce conductrice 3. Le diamètre intérieur de la pièce 7 est quant à lui choisi de façon à être très légèrement supérieur au diamètre extérieur du corps cylindrique 21 de la première pièce conductrice 3, pour éviter tout contact avec ce dernier lorsque la pièce 7 est assemblée sur la pièce 3. Le choix du diamètre intérieur de la pièce 7 ainsi que du diamètre extérieur du corps cylindrique 21 de la pièce 3 est également effectué de façon à ce que l'espace 33 séparant l'une et l'autre pièces lorsque celles-ci sont assemblées, soit suffisamment large pour éviter tout phénomène de claquage tout en étant suffisamment faible pour que la bobine 37 soit la plus recouverte possible à l'intérieur du capteur 1 et par conséquent la mieux blindée possible.

Pour recevoir la bobine 37, la périphérie intérieure de l'extrémité inférieure 27 du manchon 7 en contact avec la base 25, comprend un retrait annulaire 35 de dimension suffisante pour recevoir et maintenir la bobine 37.

Selon un autre mode de réalisation de l'invention illustré sur la figure 4 où toutes les pièces identiques à celles illustrées sur les figures 2 et 3 ont été identifiées avec les mêmes références numériques avec un indice prime « ' », la bobine 37', au lieu d'être disposée dans un retrait annulaire prévu dans l'extrémité inférieure du manchon 7, est disposée dans une gorge annulaire 55 prévue dans la base 25' au pied du corps cylindrique 21'. Dans ce cas particulier, la périphérie intérieure de l'extrémité inférieure du manchon 7' en contact avec la surface supérieure de la base 25' est avantageusement pourvue d'un épaulement annulaire 57 de faible hauteur, faisant partie intégrale du manchon 7. Cet épaulement 57 est dimensionné et positionné pour s'emboîter précisément dans la gorge 55 prévu dans la base 25' du capteur tel qu'illustré clairement sur la figure 4. Cet arrangement facilite avantageusement le centrage de la pièce 7' sur la pièce 3' puisque l'épaulement assure un autocentrage de ladite pièce 7' dans la gorge 55 de la pièce 3'.

Dans l'un et l'autre des modes de réalisation illustrés, les pièces 3 et 7 peuvent être fixées l'une à l'autre par tout moyen approprié, tels que par exemple des vis ou goujons 8 insérés dans des trous taraudés prévus à cet effet.

Tel que précédemment indiqué, la seconde pièce conductrice 7 supporte la seconde borne d'attache 9. Il est important que cette seconde borne d'attache soit disposée du même côté de la bobine que la première borne d'attache 5. En effet, seule cette disposition assure un blindage efficace de la bobine, puisqu'elle assure que le courant circulant entre les bornes 5 et 9 non seulement passe via la première pièce 3 entièrement à l'intérieur de la bobine, mais également, via la base 25 et le manchon 7, tout autour de la périphérie extérieure de la bobine tel qu'illustré avec des flèches sur la figure 3. Cette structure particulière du capteur assure donc non seulement un passage complet du courant à mesurer au sein de la bobine, ce qui est bien entendu essentiel à la mesure à effectuer, mais également un blindage de cette même bobine par le courant à mesurer. De cette façon également, l'inductance primaire du capteur est minimisée, ce qui est indispensable à une bande passante très élevée.

Tout comme la borne d'attache 5, la borne 9 peut être fixée de façon amovible, à l'aide de tout moyen approprié tel que des vis.

Il est à signaler qu'un petit canal 41 peut être avantageusement pourvu dans la base 25 de la pièce conductrice 3 pour laisser passer les bornes de sortie 39 de la bobine 37.

Dans le cas où le courant à mesurer est capté sur des lignes de très haute tension telles que des lignes de transport de 735 kV, la tension ε aux bornes 39 de la bobine 37, ne peut malheureusement pas être traitée à proximité du capteur compte tenu du problème d'isolation que cela soulève.

En conséquence, selon un mode de réalisation préféré de l'invention, le capteur 1 précédemment décrit doit être pourvu d'un circuit de prétraitement permettant une transmission du signal captée à une distance suffisante à la ligne L pour ne pas fausser les résultats de la mesure.

Pour ce faire, le capteur 1 précédemment décrit est pourvu de la troisième pièce 11 prévue pour contenir et protéger le circuit de prétraitement 43 qui sera décrit en détail ci-après.

Tel qu'illustré sur les figures 2 et 3, la troisième pièce 11 formant boîtier comprend un corps cylindrique 45 de diamètre extérieur sensiblement égal au diamètre extérieur de la base 25. Ce corps cylindrique 45 est pourvu d'un rebord périphérique interne 47 dans sa partie supérieure, et d'un mince rebord périphérique interne dans sa partie inférieure. Le rebord 47 permet la fixation du cylindre 45 à même la surface inférieure 29 de la base 25 à l'aide de vis ou de goujons 49 insérés dans des trous 48. Le rebord périphérique interne à l'autre extrémité du cylindre permet la fixation du fond 13 à l'aide de vis ou de goujons 51. L'avantage d'avoir un tel fond 13 facilement démontable est bien entendu de permettre un accès facile au circuit de prétraitement 43 au sein du cylindre 45, et, il va sans dire, un assemblage facile du corps 45 à même la base 25 du capteur.

La troisième pièce 11 en forme de boîtier fait donc, une fois installée, partie intégrante du capteur et protège le circuit de prétraitement 43, lequel circuit est relié au récepteur convertisseur 17 tel qu'illustré sur la figure 1, par tout moyen de transmission isolant approprié, telle qu'une fibre optique 15.

Avantageusement, pour éviter tout problème de surchauffe, les diverses pièces constitutrices du capteur peuvent être pourvues d'ailettes de refroidissement 53 telles qu'illustrées sur la figure 4. Ces ailettes de refroidissement peuvent être placées sur toute ou une partie seulement de la périphérie du capteur, selon les exigences de construction et/ou d'utilisation.

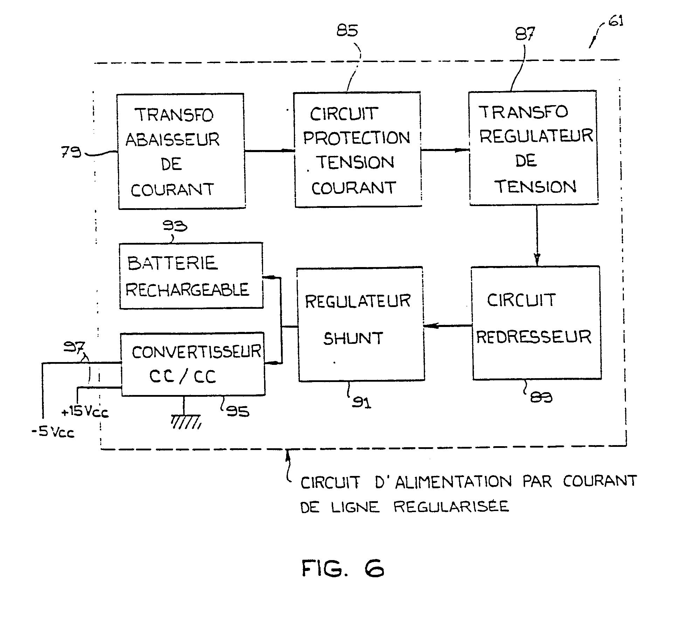

Se référant maintenant aux figures 3 et 6, le circuit de prétraitement 43 du signal capté par la bobine de Rogowski 37 peut être alimenté par des batteries. Toutefois, on préférera prévoir un circuit d'alimentation intégré 61, alimenté par un transformateur de courant intégré lui-même au capteur. Cet arrangement présente en effet l'avantage de ne requérir aucun raccordement externe pour alimenter le circuit de prétraitement, en autant qu'un courant alternatif à mesurer ou encore que le courant alternatif principal portant la variation de courant à mesurer est d'intensité et de durée satisfaisantes.

Le transformateur d'alimentation intégré au capteur peut être constitué par une bobine toroïdale 79 disposée dans une rainure annulaire 77 prévue dans une quatrième pièce conductrice 71 qui peut être fixée directement sous la base 25 de la première pièce conductrice 3 au moyen de vis ou de goujons 75. Pour faciliter le positionnement et le centrage de cette pièce conductrice 71, un pivot central 73 peut être prévu tel qu'illustré sur la figure 3.

La quatrième pièce conductrice 71 qui est en contact direct avec la première pièce conductrice 3, agit comme un élément de dérivation d'une partie du courant I circulant dans ladite pièce 3. La portion $i_2$ du courant ainsi dérivé par la pièce 71 à travers le centre de la bobine 79 génère aux bornes 81 de cette dernière une tension qui peut être transmise via un petit passage 83 au circuit d'alimentation intégré 61.

La bobine 79 peut être constituée par un simple bobinage sur un noyau qui peut être par exemple de ferrite. Pour obtenir un courant d'alimentation suffisant, il est nécessaire que la quatrième pièce conductrice 71 fixée en dessous de la base du capteur et au milieu de celui-ci, ait des surfaces en contact avec la base de dimension choisie pour établir une dérivation prédéterminée de courant. Une telle dérivation assure une tension de sortie prédéterminée aux bornes 81 de la bobine qui soit suffisante pour alimenter le circuit de prétraitement (environ 300 milli-watts en permanence, soit 5 volts et 60 milliampères dans le cas de la transmission par mode analogique décrite ci-après). En fonction des surfaces de contact choisies pour la quatrième pièce 71, on peut facilement ajuster les plages de courant ainsi dérivé et par conséquent adapter facilement la puissance requise par le circuit de prétraitement lorsque cette méthode est applicable.

En plus de la bobine 79, le circuit d'alimentation intégré 61 comprend un circuit de protection tension-courant 85 pour protéger les autres éléments du circuit d'alimentation intégré 61 ainsi que le circuit de prétraitement 43 des pointes excessives de courant et de tension. Le circuit 71 comprend également un transformateur régulateur de tension 87 pour également protéger l'ensemble du circuit en aval des fluctuations rapides de courant. En outre, le circuit d'alimentation intégré 61 comprend un circuit redresseur 89 ainsi qu'un régulateur shunt 91 relié, d'une part, à un jeu de batteries rechargeables 93 et, d'autre part, à un convertisseur cc-cc 95 dont les bornes 97 servent d'alimentation au circuit de prétraitement. Comme on peut facilement le comprendre, le courant capté par dérivation non seulement permet d'alimenter le circuit de prétraitement 43 via le convertisseur 95, mais assure également un rechargement automatique des batteries 93 qui, en cas de perte de courant de ligne, viennent se substituer à l'alimentation par dérivation et peuvent ainsi assurer une autonomie de fonctionnement au circuit de prétraitement pendant une période de temps prédéterminée, comme, par exemple, 48 heures.

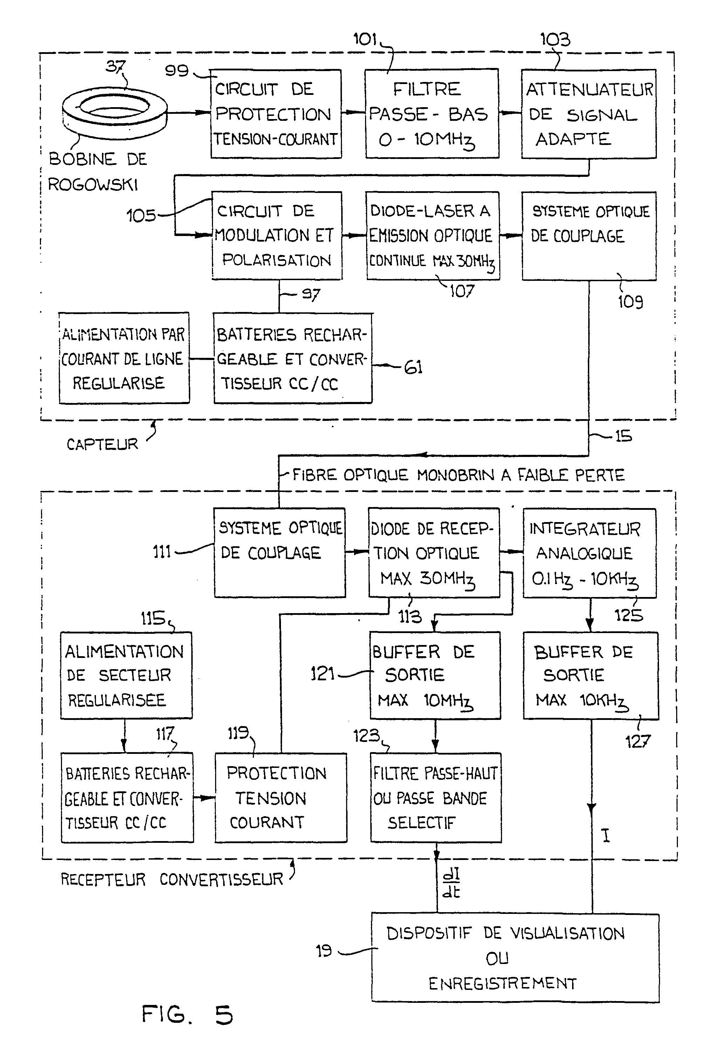

Se référant maintenant à la figure 5, le circuit de prétraitement 43 disposé à l'intérieur du boîtier 11 comprend, comme principal élément, un convertisseur de signal pour transformer en signal optique la tension générée aux bornes de la bobine 37, ainsi qu'un transmetteur optique d'isolation pour transmettre à l'extérieur du boîtier le signal optique du convertisseur.

Dans le cas particulier du mode de réalisation illustré sur la figure 5, le convertisseur de signal est constitué par une diode laser 107, trois watts dans le rouge, à émission optique continue de bande passante inférieure à 30 MHz. Le transmetteur optique d'isolation est quant à lui constitué par la fibre optique 15 reliée à la diode laser 107 par un système optique de couplage 109 de type conventionnel. Par précaution, la diode laser 107 peut être protégée contre les surtensions, les pointes de courant trop élevées et des bruits électro-magnétiques par interposition d'un circuit de protection tension-courant 99, d'un filtre 101 de bande passante comprise entre 0 et 10 MHz par exemple, d'un atténuateur de signal adapté 103 et d'un circuit de modulation et de polarisation 105 disposé en série entre les bornes de la bobine de Rogowski 37 et la diode laser 107. Le circuit de modulation et de polarisation 105 est, quant à lui, alimenté par le circuit d'alimentation intégré 61.

Comme on peut facilement le comprendre à la lecture de ce qui précède, le signal ε du capteur est donc transmis à l'extérieur de ce dernier par la fibre optique 15 selon le mode analogique, c'est-à-dire par conversion directe du signal électrique ε aux bornes de la bobine toroïdale en un signal optique. L'avantage d'utiliser le mode analogique réside principalement dans le fait que ce mode est beaucoup plus facilement immunisé contre les perturbations que le mode digital et qu'il s'avère beaucoup plus simple que ce dernier.

La fibre optique 15 peut avoir une longueur relativement grande (jusqu'à 100 mètres) sans affecter l'efficacité de la transmission. Pour ce faire, on utilise avantageusement une fibre optique à faible perte.

Le récepteur convertisseur 17 comprend quant à lui un système de diode de réception optique pour retransformer le signal optique en un signal électrique. Cette diode de réception optique 113 doit être choisie de façon à avoir une bande passante sensiblement identique à celle de la diode du capteur. De préférence, cette diode 113 sera une diode PIN de type commercial, telle que celle commercialisée par la société Analogue Modules Inc. sous la désignation LNVA/0/AG/PIN. Cette diode de réception optique est alimentée par un système d'alimentation de secteur régularisé 115 relié à un jeu de batteries rechargeables et à un convertisseur cc-cc 117 de façon à assurer une certaine autonomie du système en cas de panne d'alimentation. Les batteries et/ou le convertisseur 117 alimente la diode 113 via un circuit de protection tension-courant 119.

Bien entendu, la diode de réception optique 113 reçoit le signal optique transmis par le capteur via la fibre 15, au moyen d'un système optique de couplage 111.

Tel que précédemment indiqué dans le préambule de la présente demande, on choisit de préférence la bobine 37 de façon à ce que le signal ε capté soit proportionnel à la dérivée du courant I circulant dans la ligne L.

Dans ce cas particulier, le signal électrique aux bornes de la diode PIN 113 peut être traité de deux façons selon les besoins de l'utilisateur.

Ainsi, si l'on veut utiliser le capteur pour mesurer le courant I, le signal électrique à la sortie de la diode 113 est transmis à un intégrateur amplificateur analogique de bande passante comprise entre 0.1 Hz et 10 kHz 125, associé à un buffer de sortie 127 de bande passante maximum de 10 kHz par exemple. La qualité du résultat obtenu avec un tel circuit équivaut au moins aux résultats obtenus avec les systèmes conventionnels. En effet, on peut, avec un tel circuit, mesurer le courant I circulant dans la ligne avec une fiabilité minimum garantie de 1 % ou mieux et un déphasage minimum dans la plage de fréquences indiquée.

Si l'on veut utiliser le capteur 1 pour mesurer les fluctuations de courant selon le mode différenciateur, le signal électrique à la sortie de la diode 113 est alors reproduit tel quel après être passé dans un buffer de sortie 121 de bande passante maximum de 10 MHz et soit un filtre passe haut, soit un filtre passe bande sélectif 123. Si nécessaire, un amplificateur de bande passante de 10 MHz par exemple peut également être utilisé. L'utilisation d'un filtre passe haut 123 a l'avantage d'éliminer les composantes à 60 et 120 hertz pour ne garder que le contenu haute fréquence. Si on désire mesurer le contenu des harmoniques supérieures (3, 10, 100 etc.) ou encore procéder à une analyse transitoire, ce filtre passe haut peut être substitué tel que précédemment indiqué par un filtre passe bande sélectif.

Dans l'un et l'autre de ces deux modes de mesure, le signal traité peut être reproduit sur n'importe quel dispositif de visualisation ou d'enregistrement 19, tel qu'un oscilloscope, un visicordeur, ou un enregistreur par bande magnétique.

Tel que précédemment indiqué dans le préambule de la présente demande, le principal avantage du capteur 1 selon l'invention et de l'ensemble de l'appareillage incorporant ce capteur 1 qui alimente à distance un récepteur convertisseur, réside dans le fait qu'il peut supporter sans protection un fort courant de secteur, tel que le courant de coupure d'un disjoncteur, tout en ne se saturant pas et en permettant une mesure sensible du faible courant post-arc.

La sensibilité de cet appareillage est d'ailleurs telle que l'on peut effectuer des mesures précises pour des fréquences de 1 cycle à plusieurs mégacycles, sous des courants aussi élevés que 50 000 ampères EFF et plus.

La bobine de Rogowski se trouvant placée, grâce à la structure du capteur, directement dans le conducteur lui-même, aucun risque de déplacement n'est à redouter. De plus, cette structure du capteur permet d'éviter de nombreux inconvénients qui, jusqu'à présent, faisaient rejeter l'utilisation d'une telle bobine de Rogowski dans le sens différenciateur, grâce surtout au blindage « naturel » que le capteur fournit à la bobine.

De par sa structure qui le rend non saturable et à faible échauffement, le capteur 1 peut être utilisé comme moniteur de courant dans n'importe quel type de circuit, inclus ceux subissant des situations de chocs à courant élevé et à front raide. Le capteur 1 peut être également utilisé dans tout circuit subissant une variation de courant importante dans le temps et où l'analyse de ces fluctuations rapides est requise.

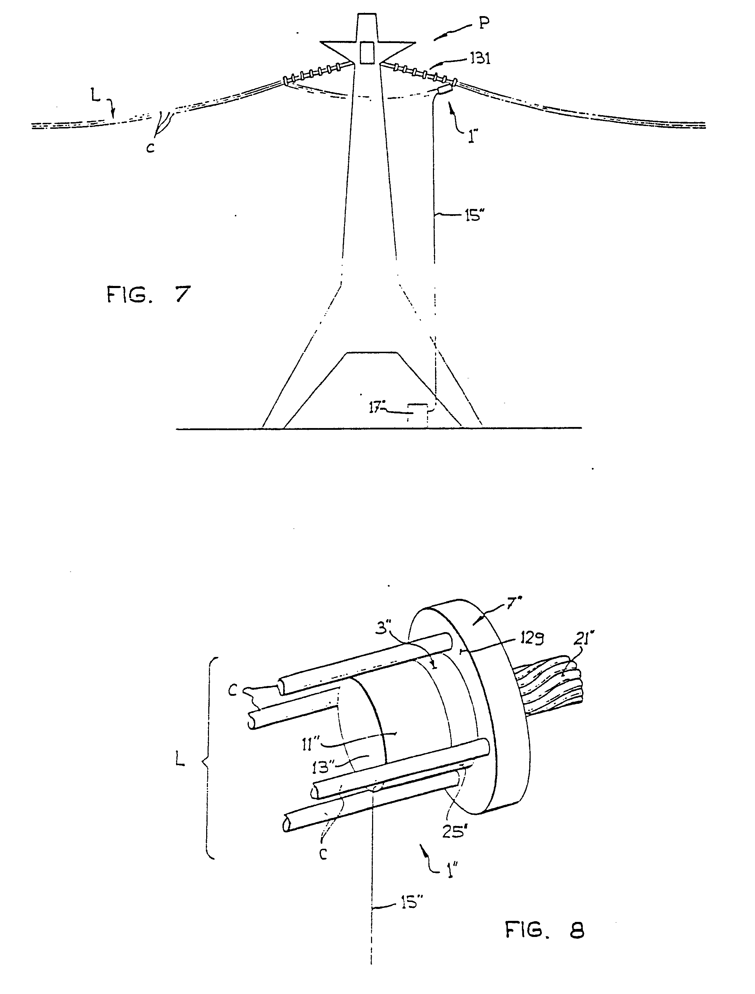

Les figures 7 et 8 illustrent un exemple de l'application du capteur de courant selon l'invention sur une ligne de transport, à même un pylône P. Les pièces du capteur ou de l'appareillage incluant ce capteur sont identifiées sur ces figures avec les mêmes numéros que sur les figures précédentes, avec un indice seconde (").

Comme on peut le constater, le capteur 1" peut être fixé sur le pylône P à l'extrémité d'un des isolateurs 131 retenant la ligne L. Dans le cas des lignes de transport de haute tension, la ligne L est constituée par une pluralité de câbles C. Pour assurer le montage du capteur 1", on peut alors aisément prévoir un élargissement de la seconde pièce conductrice 7" de façon à fournir une surface périphérique 129 sur laquelle les câbles C peuvent venir s'attacher. Dans ce cas, il est bien entendu qu'aucune borne d'attache 9 n'est nécessaire. La première pièce conductrice 3" du capteur peut quant à elle, avoir son corps cylindrique 21" prolongé pour venir se raccorder au système de raccordement habituel placé à l'extrémité de l'isolateur 131. Bien entendu, le capteur 1" peut être pourvu d'un boîtier 11" et être relié au sol par une fibre optique 15" tel qu'il a été précédemment indiqué, à condition que le mode choisi garantisse un niveau d'isolation satisfaisant par rapport à la tension d'opération sans quoi il serait indispensable d'amener le signal par un isolateur secondaire à traversée centrale, ce qui s'avère quand même peu onéreux.

**Revendications**

1. Capteur dynamique de courant destiné à équiper une ligne d'alimentation électrique à très fort courant et à haute ou très haute tension, du type comportant une bobine de Rogowski (37) au centre de laquelle passe complètement une première pièce conductrice (3) traversée par le courant à capter, la bobine étant choisie de façon que le rapport de sa self-inductance sur l'impédance totale vue de ladite bobine soit très inférieur à la période du courant à capter et une enceinte comportant une deuxième pièce conductrice (7) entourant ladite bobine (37) dans un but d'isolation de celle-ci, caractérisé en ce que la première pièce conductrice comporte un corps cylindrique plein (21) de diamètre inférieur au diamètre intérieur de la bobine (37), s'étendant perpendiculairement à une base (25) de diamètre supérieur au diamètre extérieur de la bobine (37), en ce que la seconde pièce conductrice est montée sur la première et comporte un manchon épais (7) entourant la première pièce conductrice et prenant contact sur la périphérie extérieure de la base (25) tout autour de la bobine (37), le diamètre intérieur du manchon (7) étant légèrement supérieur au diamètre extérieur du corps cylindrique plein (21) pour éviter tout contact avec ce dernier lorsque les pièces (3, 7) sont fixées, une première borne d'attache (5) étant prévue à l'extrémité supérieure (23) du corps cylindrique plein (21) à l'opposé de ladite base (25) et une deuxième borne d'attache (9) étant prévue sur ledit manchon (7) du même côté de la bobine (37) que ladite première borne d'attache (5), ledit capteur comprenant en outre une troisième pièce (11) en forme de boîtier fixé sous la base (25) de la première pièce (3) pour recevoir un circuit de prétraitement (43) du courant capté par la bobine (37), ladite bobine (37) étant reliée à l'intérieur dudit boîtier (11) via une petite ouverture (41) traversant ladite base (25), ledit circuit de prétraitement (43) étant alimenté par un transformateur d'alimentation (79) intégré au capteur (1) et constitué par une bobine toroïdale (79) montée sur un noyau de ferrite, ledit transformateur étant lui-même alimenté par un élément de dérivation (71) du courant intégré au capteur (1).

2. Capteur selon la revendication 1, caractérisé en ce que la périphérie intérieure de l'extrémité (27) du manchon (7) en contact avec la base (25) comprend un retrait annulaire (35) pour recevoir et maintenir la bobine (37).

3. Capteur selon la revendication 1, caractérisé en ce que la base (25') de la première pièce (3') comprend une gorge annulaire (55) au pied du corps cylindrique (21') pour recevoir et maintenir la bobine (37').

4. Capteur selon la revendication 3, caractérisé en ce que la périphérie intérieure de l'extrémité du manchon (7') en contact avec la base (25') comprend un épaulement annulaire (57) de faible hauteur, dimensionné et positionné pour s'emboîter dans la gorge (55) de la base (25') de façon à auto-centrer la seconde pièce (7') par rapport à la première pièce (3').

5. Capteur selon l'une quelconque des revendications 1 à 4, caractérisé en ce que les premières et seconde pièces (3, 7) sont fixées ensemble à l'aide de goujons (8) vissés dans des trous taraudés.

6. Capteur selon l'une quelconque des revendications 1 à 5, caractérisé en ce que le boîtier (11') est pourvu d'ailettes de refroidissement (53) sur au moins une partie de sa surface latérale extérieure.

7. Capteur selon l'une quelconque des revendications 1 à 6, caractérisé en ce que le boîtier (11) est pourvu à une extrémité d'un rebord périphérique intérieur (47) et à l'autre extrémité d'un fond démontable (13), ledit boîtier (11) étant fixé de façon amovible à la base (25) par des goujons (49) passant dans ledit rebord périphérique intérieur (47).

8. Capteur selon l'une quelconque des revendications 1 à 7, caractérisé en ce que le circuit de prétraitement (43) inclut un circuit de protection (85) contre les surtensions, contre les pointes de courant trop élevées et contre les bruits électromagnétiques.

9. Capteur selon l'une quelconque des revendications 1 à 8, caractérisé en ce que le circuit de prétraitement (43) placé au sein du boîtier (11) comprend un convertisseur de signal constitué par une diode à émission optique continue (107) dotée d'un circuit de modulation et polarisation (105) de bande passante maximum égale à 30 MHz, pour transformer en signal optique la tension générée aux bornes de la bobine (37) passant dans la petite ouverture (41), laquelle tension est directement proportionnelle à la variation de courant dans le conducteur, et un transmetteur optique d'isolation (15), comportant une fibre optique sortant du boîtier (11), pour transmettre à l'extérieur du boîtier (11) le signal optique du convertisseur (107).

10. Capteur selon l'une quelconque des revendications 1 à 9, caractérisé en ce que ledit élément de dérivation du courant intégré au capteur (1) est constitué par une quatrième pièce conductrice (71) fixée en dessous de la base (25) du capteur (1) au milieu de celui-ci, ladite quatrième pièce (71) présentant une gorge annulaire (77) pour recevoir la bobine toroïdale (79) et des surfaces en contact avec la base (25) pour établir une dérivation du courant circulant dans ladite base (25) à l'intérieur de ladite bobine toroïdale (79), en ce que les surfaces de contact de ladite quatrième pièce conductrice (71) sont adaptées à la plage de courant de la ligne haute tension, et en ce que la bobine toroïdale (79) alimente le circuit de prétraitement (43) via un transformateur régulateur de tension ajustable (87), un circuit redresseur (89) et un régulateur shunt (91).

11. Appareil de mesure de courant caractérisé en ce qu'il comprend un capteur dynamique de courant (1), tel que défini dans la revendication 9, relié à un récepteur convertisseur (17) par la fibre optique (15) sortant du boîtier (11) du capteur (1), ledit récepteur convertisseur (17) comprenant une diode de réception optique (113) de bande passante sensiblement identique à celle de la diode émettrice (107) du capteur de courant (1) ; ladite diode de réception optique (113) délivrant un signal directement proportionnel à la variation du courant passant dans le capteur (1) avec une sensibilité comparable aussi bien dans la phase fort-courant que dans la phase transitoire rapide d'un faible courant post-arc.

12. Appareil selon la revendication 11, caractérisé en ce que le récepteur convertisseur (17) comprend également un buffer de sortie (121) relié à la diode (113), ainsi qu'un filtre passe-bande sélectif (123) relié au buffer de sortie (121).

13. Appareil selon la revendication 11, pour la mesure du courant circulant dans le capteur (1), caractérisé en ce que le récepteur convertisseur (17) comprend en outre un intégrateur amplificateur (125) de bande passante comprise entre 0,1 et 10 KHz relié à la diode (113) pour traiter le signal délivré par celle-ci.

## Claims

1. A dynamic current transducer intented to be used on a very high current, high or very high voltage transmission line, of the type comprising a Rogowski coil (37) through the middle of which passes a first conducting element (3) in which the current to be sensed flows, the coil being selected so that the ratio of its self-inductance with respect to the total impedance viewed by said coil is much smaller than the period of the current to be sensed, and a housing comprising a second conducting element (7) embedding said coil (37) to shield the same, characterized in that : the first conducting element comprises a solid cylindrical body (21) having a diameter smaller than the internal diameter of the coil (37), said body extending perpendicularly to a solid base (25) having a diameter higher than the external diameter of the coil, and in that : the second conducting element is mounted onto the first conducting element and comprises a thick sleeve (7) surrounding the first conducting element and contacting the internal periphery of the base (25) all around the coil (37), the internal diameter of the sleeve (7) being slightly greater than the external diameter of the solid cylindrical body (21) to avoid any contact with the same when the first and second elements (3, 7) are connected to each other, a first terminal connector (5) being provided at the upper end (23) of the solid cylindrical body (21) opposite to the base (25) and a second terminal connector (9) being provided onto the sleeve (7) of the same side of the coil (37) as the first terminal connector (5) ; said transducer further comprising a third box-shaped element (11) fixed under the base (25) of the first element (3) and containing a circuit (43) for pretreating the current sensed by the coil (37), said coil (37) being connected to said pretreatment circuit inside the box-shaped element (11) via a small opening (41) extending through the base (25), said pretreatment circuit (43) being supplied by a transformer (79) integrated to the transducer (1) and comprising a toroidal coil (79) mounted onto a ferrite core, said transformer being itself supplied by a current-tapping element (71) integrated to the transducer (1).

2. A current transducer according to claim 1, characterized in that the internal periphery of the end (27) of the sleeve (7) in contact with the base (25) comprises an annular recess (35) for receiving and holding the coil (37).

3. A current transducer according to claim 1, characterized in that the base (25') of the first conducting element (3') comprises an annular groove (55) adjacent to the foot of the cylindrical body (21') for receiving and holding the coil.

4. A current transducer according to claim 3, characterized in that the internal periphery of the end of the sleeve (7') in contact with the base (25') also comprises an annular shoulder (57) of small height, which shoulder is sized and positioned to match the groove (55) in the base (25') so as to self-position the second conducting element (7') with respect to the first element (3').

5. A current transducer according to anyone of claims 1 to 4, characterized in that the first and second conducting elements (3, 7) are fixed to each other by bolts (8) screwed into threaded holes.

6. A current transducer according to anyone of claims 1 to 5, characterized in that the box-shaped element (11') is provided with cooling fins (53) on at least one part of its external surface.

7. A current transducer according to anyone of claims 1 to 6, characterized in that the box-shaped element (11) is provided at one end with an internal peripherical flange (47) and at the other end with a removable bottom (13), said box-shaped element (11) being fixed in a removable manner onto the base (25) by means of bolts (49) passing through said internal peripherical flange (47).

8. A current transducer according to anyone of claims 1 to 7, characterized in that the pretreatment circuit (43) includes a protection circuit (85) against over-voltage, high current peaks and electromagnetic interferences.

9. A current transducer according to anyone of claims 1 to 8, characterized in that the pretreatment circuit (43) located inside the box-shaped element (11) comprises a signal converter consisting of a continuous wave laser diode (107) connected to a bias and modulation circuit (105) having a maximal frequency pass-band of 30 MHz, for converting into an optical signal the output voltage signal generated at the terminals of the coil (37) passing through the small opening (41), which voltage is directly proportional to any variation of current in the conductor, and a fiber optic transmitter (15) comprising an optic fiber extending out of the box-shaped element (11), for transmitting the optical signal from the converter (107) to a location outside of the box-shaped element (11).

10. A current transducer according to anyone of claims 1 to 9, characterized in that the current tapping element integrated to the transducer (1) consists of a fourth conducting element (71) fixed onto the middle of the bottom of the base (25) of the transducer (1), said fourth conducting element (71) having an annular groove (77) for receiving the toroide coil (79) and a pair of surfaces in contact with the base (25) for tapping the current circulating through this base (25) inside said toroidal coil (79) ; in that the contact surfaces of said fourth conducting element (71) are sized to correspond to the range of current flowing through the transmission line ; and in that the toroidal coil (79) supplies the pretreatment circuit (43) through an adjustable voltage regulating transformer (87), a rectifying circuit (89) and a shunt regulator (91).

11. An apparatus for measuring a current, characterized in that it comprises a dynamic current transducer (1) as defined in claim 9, connected to a receiving converter (17) by the optic fiber (15) extending out of the box-shaped element (11) of the transducer (1), said receiving converter (17) comprising a photodiode (113) having a frequency pass band substantially identical to the pass band of the laser diode (107) of the current transducer (1), said photodiode (113) giving an output signal directly proportional to the variation of current flowing through the transducer (1) with a sensitivity substantially constant under the high current phase and the short transitory phase of a post-arch current.

12. An apparatus according to claim 11, characterized in that the receiving converter (17) also comprises an outer buffer (121) connected to the receiving diode (113) and a selective pass band filter (123) connected to the output buffer (121).

13. An apparatus according to claim 11 for measuring the intensity of the current flowing through the transducer (1), characterized in that the receiving converter (17) also comprises an integrator-amplifier (125) having a pass band ranging between 0.1 to 10 kHz, connected to the receiving diode (113) for treating the output signal of said receiving diode.

**Patentansprüche**

1. Dynamischer Stromsensor zur Ausrüstung einer elektrischen Versorgungsleitung für sehr hohe Ströme und hohe oder sehr hohe Spannungen mit einer Rogowski-Spule (37), deren Zentrum vollständig von einem ersten Leiterstück durchdrungen ist, das von dem zu erfassenden Strom durchflossen wird, wobei die Spule derart gewählt ist, daß das Verhältnis zwischen ihrer Induktivität und der von ihr aus gesehenen Gesamtimpedanz sehr viel kleiner ist als die Periodendauer des zu erfassenden Stroms, sowie mit einer Umhüllung mit einem zweiten Leiterstück (7), das die Spule (37) zum Zweck der Isolation umschließt, dadurch gekennzeichnet, daß das erste Leiterstück aus einem vollzylindrischen Körper (21) besteht, dessen Durchmesser kleiner ist als der Innendurchmesser der Spule (37) und der sich senkrecht zu einer Basis (25) erstreckt, deren Durchmesser größer ist als der Außendurchmesser der Spule (37), daß das zweite Leiterstück auf dem ersten Leiterstück montiert und ist aus einer dickwandigen Buchse (7) besteht, die das erste Leiterstück umschließt und im Bereich um die Spule (37) den äußeren Umfangsbereich der Basis (25) berührt, wobei der Innendurchmesser der Buchse (7) geringfügig größer ist als der Außendurchmesser des vollzylindrischen Körpers (21), um jede Berührung mit letzterem zu verhindern, wenn die Leiterstücke (3, 7) fixiert sind, daß an dem oberen Ende (23) des vollzylindrischen Körpers (21) auf der der genannten Basis (25) abgewandten Seite eine erste Anschlußklemme (5) vorgesehen ist und an der Buchse (7) eine zweite Anschlußklemme (9) vorgesehen ist, die sich auf derselben Seite der Spule (37) befindet wie die erste Anschlußklemme (5), daß der Stromsensor ferner ein unter der Basis (25) des ersten Leiterstücks (3) befestigtes drittes Teil in Form einer Dose (11) umfaßt, in der eine Vorverarbeitungsschaltung (43) für den von der Spule (37) erfaßten Strom aufgenommen ist, daß die Spule (37) über eine kleine die Basis (25) durchdringende Öffnung (41) mit dem Innern der genannten Dose (11) verbunden ist, und daß die Vorverarbeitungsschaltung (43) von einem in dem Stromsensor (1) integrierten Speisetransformator (79) gespeist wird, der aus einer auf einem Ferritkern montierten Ringspule (79) besteht und seinerseits von einem in dem Stromsensor (1) integrierten Stromabzweigungselement (71) gespeist wird.

2. Stromsensor nach Anspruch 1, dadurch gekennzeichnet, daß an dem Innenumfang des die Basis (25) berührenden Endbereichs (27) der Buchse (7) ein ringförmiger Absatz (35) zur Aufnahme und Halterung der Spule (37) angebracht ist.

3. Stromsensor nach Anspruch 1, dadurch gekennzeichnet, daß die Basis (25') des ersten Leiterstücks (3') am Fuß des zylindrischen Körpers (21') eine ringförmige Kehle (55) zur Aufnahme und Halterung der Spule (37) besitzt.

4. Stromsensor nach Anspruch 3, dadurch gekennzeichnet, daß an dem Innenumfang des mit der Basis (25') in Berührung stehenden Endbereichs der Buchse (7') eine ringförmige Schulter (57) geringer Höhe gebildet ist, die derart bemessen und positioniert ist, daß sie sich in die Kehle (55) der Basis (25') derart eingefügt, daß sie das zweite Leiterstück (7') relativ zu dem ersten Leiterstück (3') selbsttätig zentriert.

5. Stromsensor nach einem der Ansprüche 1 bis 4, dadurch gekennzeichnet, daß das erste und das zweite Leiterstück (3, 7) mit Hilfe von in Gewindebohrungen eingeschraubten Bolzen (8) fest miteinander verbunden sind.

6. Stromsensor nach einem der Ansprüche 1 bis 5, dadurch gekennzeichnet, daß die Dose (11') auf wenigstens einem Teile ihrer seilichen Außenfläche Kühlrippen (53) besitzt.

7. Stromsensor nach einem der Ansprüche 1 bis 6, dadurch gekennzeichnet, daß die Dose (11) an einem Ende einen umlaufenden Innenrand (47) und an dem anderen Ende einen demontierbaren Boden (13) aufweist und mit Hilfe von Bolzen (49), die diesen umlaufenden Innenrand (47) durchdringen, lösbar an der Basis (25) befestigt ist.

8. Stromsensor nach einem der Ansprüche 1 bis 7, dadurch gekennzeichnet, daß die Vorverarbeitungsschaltung (43) eine Schutzschaltung (85) zum Schutz gegen Überspannungen, gegen zu hohe Stromspitzen und gegen elektromagnetisches Rauschen aufweist.

9. Stromsensor nach einem der Ansprüche 1 bis 8, dadurch gekennzeichnet, daß die im Innern der Dose (11) angeordnete Vorverarbeitungsschaltung (43) einen Signalwandler enthält, der von einer Diode (107) mit kontinuierlicher optischer Emission gebildet ist, die mit einer Modulations- und Polarisationsschaltung (105) für ein Durchlaßband von maximal 30 MHz verbunden ist und dazu dient, die an den durch die genannte kleine Öffnung (41) geführten Anschlüssen der Spule (37) erzeugte Spannung, die der Stromänderung in dem Leiter direkt proportional ist, in ein optisches Signal umzuwandeln, und daß die Vorverarbeitungsschaltung (43) außerdem einen isolierenden optischen Übertrager (15) mit einer aus der Dose (11) herausführenden optischen Faser zur Übertragung des optischen Signals des Wandlers (107) aus der Dose (11) enthält.

10. Stromsensor nach einem der Ansprüche 1 bis 9, dadurch gekennzeichnet, daß das in dem Stromsensor (1) integrierte Stromabzweigungselement von einem vierten Leiterstück (71) gebildet ist, das unter der Basis (25) des Stromsensors in dessen Mitte befestigt ist und eine ringförmige Kehle (77) zur Aufnahme der Ringspule (79) sowie Flächen besitzt, die mit der Basis (25) in Berührung stehen und eine Abzweigung des durch die Basis (25) zirkulierenden Stroms ins Innere der Ringspule (79) zu bewirken, daß die Berührungsflächen des vierten Leiterstücks (71) an den Strombereich der Hochspannungsleitung angepaßt sind, und daß die Ringspule (79) über einen einstellbaren Spannungsregeltransformator (87), eine Gleichrichterschaltung (89) und einen Shunt-Regler (91) die Vorverarbeitungsschaltung (43) speist.

11. Strommeßgerät, dadurch gekennzeichnet, daß es einen dynamischen Stromsensor (1) nach Anspruch 9 enthält, der über die aus der Dose (11) des Stromsensors (1) austretende optische Faser (15) mit einem Empfänger-Konverter (17) verbunden ist, der eine optische Empfängerdiode (113) besitzt, deren Durchlaßband zumindest annähernd mit dem Durchlaßband der emittierenden Diode (107) des Stromsensors (1) übereinstimmt, daß die optische Emfängerdiode (113) ein der Änderung des durch den Stromsensor (1) fließenden Stroms direkt proportionales Signal mit vergleichbarer Empfindlichkeit in der Starkstromphase und ebenso in der raschen Schwachstromübergangsphase nach einer Bogenentladung liefert.

12. Gerät nach Anspruch 11, dadurch gekennzeichnet, daß der Empfänger-Konverter (17) ferner einen mit der Diode (113) verbundenen Ausgangspuffer (121) sowie ein mit diesem verbundenes selektives Bandpaßfilter (123) aufweist.

13. Gerät nach Anspruch 11 zur Messung des in dem Stromsensor (1) zirkulierden Stroms, dadurch gekennzeichnet, daß der Empfänger-Konverter (17) außerdem einen mit der Diode (113) verbundenen Integrationsverstärker (125) mit einem zwischen 0,1 und 10 kHz liegenden Durchlaßband für die Bearbeitung des von der Diode gelieferten Signals umfaßt.

FIG. 1

APPAREIL DE
VISUALISATION
OU ENREGISTREMENT

RECEPTEUR
CONVERTISSEUR

FIG. 2

1

FIG. 3

CIRCUIT D' ALIMENTATION INTEGRE

CIRCUIT DE PRETRAITEMENT

FIG. 4

2

FIG. 5

FIG. 6

FIG. 7

FIG. 8